# FASCICULE DE BREVET EUROPEEN

(11) **EP 4 437 593 B1**
(45) Date de publication et mention de la délivrance du brevet: **15.10.2025**
(21) Numéro de dépôt: 22818770.4
(22) Date de dépôt: 21.11.2022
(51) Int. Cl.: H10F 77/00

(54) **DISPOSITIF FONCTIONNEL À SORTIES ÉLECTRIQUES DIRECTES ET PROCÉDÉ DE FABRICATION D'UN TEL DISPOSITIF FONCTIONNEL**
FUNKTIONSEINRICHTUNG MIT DIREKTEN ELEKTRISCHEN AUSGÄNGEN UND VERFAHREN ZUR HERSTELLUNG EINER DERARTIGEN FUNKTIONSEINRICHTUNG
FUNCTIONAL DEVICE WITH DIRECT ELECTRICAL OUTPUTS AND PROCESS FOR FABRICATING SUCH A FUNCTIONAL DEVICE

(30) Priorité: 22.11.2021 FR 2112321
(43) Date de publication de la demande: 02.10.2024
(73) Titulaire: Commissariat à l'Energie Atomique et aux Energies Alternatives, 75015 Paris (FR); COLAS, 75015 Paris (FR)
(72) Inventeur: BOULANGER, Amandine, 38054 Grenoble cedex 09 (FR); HESLINGA, Dick, 38054 Grenoble cedex 09 (FR); RODIERE, Jean, 78114 Magny-les-Hameaux (FR); DE BETTIGNIES, Rémi, 38054 Grenoble cedex 09 (FR); COQUELLE, Eric, 78000 Versailles (FR); LELIEVRE, Patrick, 38054 Grenoble cedex 09 (FR)
(74) Mandataire: Jacobacci Coralis Harle
(86) Numéro de dépôt international: PCT/EP2022/082559
(87) Numéro de publication internationale: WO 2023/089161

(56) Documents cités:
- US-A1- 2008 041 434
- US-A1- 2008 156 365

## Description

### Domaine technique de l'invention

La présente invention concerne le domaine technique des dispositifs fonctionnels, par exemple des structures multicouches, comprenant des éléments électriquement ou optiquement actifs, tels que des cellules photovoltaïques, des diodes électroluminescentes ou des films résistifs.

L'invention trouve une application privilégiée dans le domaine des routes solaires. L'invention est par exemple intégrable dans des chaussées circulables par des piétons et/ou des véhicules, motorisés ou non, telles que des chaussées ou routes, des pistes cyclables, des plateformes industrielles ou aéroportuaires, des places, des trottoirs ou des parkings.

L'invention trouve également une application privilégiée dans les véhicules de transport (par exemple voiture, camion, train ou bateau) ou l'enveloppe d'un bâtiment, sur lesquels le dispositif fonctionnel peut être fixé.

Elle concerne en particulier un dispositif fonctionnel à sorties électriques directes et un procédé de fabrication d'un tel dispositif fonctionnel, destiné à être intégré dans une chaussée et une chaussée circulable ou piétonne fonctionnalisée comprenant un tel dispositif.

### Etat de la technique

Les chaussées fonctionnalisées sont des chaussées comprenant des éléments électriquement ou optiquement actifs tels que des cellules photovoltaïques ou d'autres éléments électriquement ou optiquement actifs tels que des diodes électroluminescentes (LEDs), des éléments électriques, électroniques, optiques, opto-électriques, piézo-électriques et/ou thermoélectriques. Ces éléments peuvent permettre de générer, de recevoir et/ou de communiquer des données, ou encore de générer et transférer de l'énergie.

En particulier, le principe des routes solaires consiste à utiliser les routes ou chaussées comme moyens de production d'énergie électrique, à partir de l'irradiation solaire pendant la journée.

Pour cela, des modules solaires sont insérés dans des chaussées dites circulables (routes, trottoirs, etc.), et recouverts par une surface texturée transparente, résistante au passage des véhicules, et répondant aux exigences d'adhérence applicables aux routes et autres voies circulées.

Classiquement, les modules photovoltaïques comprennent :
- une plaque transparente en face avant du module, généralement en verre ; la face avant étant celle exposée au rayonnement solaire incident lors de l'implantation des modules sur le terrain,
- un ensemble de cellules photovoltaïques interconnectées, enrobées dans une couche d'encapsulation,
- une plaque en face arrière du module photovoltaïque, généralement en verre ou en un « backsheet » formé de polymères multi-couches.

Ces modules photovoltaïques comprennent généralement, majoritairement en face arrière, une boîte de jonction. Celle-ci permet en particulier d'effectuer la transition entre les connectiques électriques intérieures au module photovoltaïque (généralement en ruban de cuivre plat) et les connectiques électriques extérieures au module photovoltaïque (généralement en câbles ronds ou plats). Cette boîte de jonction contient généralement également une ou plusieurs diodes de dérivation, nécessaire(s) au bon fonctionnement et à la protection du module photovoltaïque en cas notamment de dysfonctionnement des cellules photovoltaïques comprises dans ce module.

Cependant, dans le cas de l'installation d'un module photovoltaïque sur une chaussée, la présence d'une boîte de jonction sur le module induit des coûts d'installation élevés car il est notamment nécessaire de réaliser une tranchée dans la chaussée pour y encastrer la boîte de jonction. Cette tranchée doit ensuite être remplie d'un matériau compatible avec la chaussée et avec le passage du trafic. Une problématique similaire existe dans toute application de modules photovoltaïques fixés sur l'ensemble de la surface de leur face arrière sur un support. Un dispositif de l'art antérieur est décrit dans le document US 2008/041434 A1.

### Présentation de l'invention

Dans ce contexte, la présente invention propose d'améliorer la fabrication des dispositifs fonctionnels, en particulier ceux destinés à être intégrés dans une chaussée, de manière à réduire leurs coûts d'installation sur le support concerné. Ce support est de manière préférentielle une chaussée circulable. Il peut également s'agir de tout autre support tel que des surfaces de bâtiments, de bateaux, de voitures et plus généralement, toute surface sur laquelle le dispositif fonctionnel pourrait être posé par collage ou tout autre moyen de fixation.

En particulier, l'invention concerne un dispositif fonctionnel selon l'objet de la revendication 1, comportant un empilement multicouche. Cet empilement multicouche comprend successivement :
- un premier film de protection transparent disposé en face avant dudit dispositif,
- un ensemble encapsulant,
- un deuxième film de protection, transparent ou non, disposé en face arrière du dispositif,
- au moins un élément électriquement ou optiquement actif étant enrobé dans l'ensemble encapsulant, et
- un élément de connexion électrique raccordé audit élément électriquement ou optiquement actif et adapté à transporter l'électricité depuis ou vers ledit élément électriquement ou optiquement actif,

Selon l'invention, l'élément de connexion électrique est intégré dans l'empilement multicouche. De plus, l'élément de connexion électrique comprend une gaine extérieure dépourvue d'éléments halogènes et dont une extrémité sort directement dudit dispositif fonctionnel, de manière à s'affranchir de l'utilisation d'une boîte de jonction intermédiaire en face avant ou en face arrière du dispositif fonctionnel.

Ainsi, l'absence d'éléments halogènes dans la gaine extérieure de l'élément de connexion électrique, par exemple d'un câble électrique, permet d'obtenir une bonne adhérence entre l'ensemble encapsulant du dispositif fonctionnel et la gaine extérieure de l'élément de connexion électrique. Ceci est un facteur essentiel pour assurer une bonne étanchéité et éviter des risques de délamination au niveau de la sortie de l'élément de connexion électrique du dispositif fonctionnel.

De plus, cet agencement, intégrant directement l'élément de connexion électrique dans le dispositif fonctionnel, cet élément de connexion électrique sortant également directement à l'extérieur de ce dispositif, permet de s'affranchir de l'utilisation d'une boite de jonction intermédiaire sur la face avant ou arrière du dispositif fonctionnel. Cela permet également d'assurer la fiabilité du dispositif fonctionnel par rapport aux conditions ambiantes à ce dispositif, notamment des influences physiques, mécaniques ou chimiques subies par le dispositif.

D'autres caractéristiques non limitatives et avantageuses du dispositif conforme à l'invention, prises individuellement ou selon toutes les combinaisons techniquement possibles, sont les suivantes :
- l'élément électriquement ou optiquement actif est une cellule photovoltaïque, ladite cellule photovoltaïque étant raccordée à au moins une diode de dérivation enrobée dans l'ensemble encapsulant ;

- la gaine extérieure de l'élément de connexion électrique est dépourvue de fluoropolymère et/ou de chloropolymère et/ou de bromopolymère ;
- l'ensemble encapsulant comprend un passage permettant la sortie de l'élément de connexion électrique, au travers de l'ensemble encapsulant, vers l'extérieur du dispositif fonctionnel ;
- l'ensemble encapsulant comprend :
   a) un premier film encapsulant extérieur,
   b) un film encapsulant intérieur, et
   c) un deuxième film encapsulant extérieur ;
- l'élément de connexion électrique est enrobé de matériau encapsulant le long de son passage au travers dudit dispositif fonctionnel, ledit matériau encapsulant étant choisi parmi l'un ou plusieurs des matériaux formant le premier film encapsulant extérieur, le film encapsulant intérieur ou le deuxième film encapsulant extérieur ;
- le deuxième film encapsulant extérieur comprend un premier orifice et le deuxième film de protection comprend un deuxième orifice, le premier orifice et le deuxième orifice étant alignés de manière à former un orifice traversant permettant le passage de l'élément de connexion électrique au travers du deuxième film encapsulant extérieur et du deuxième film de protection ;
- un espace entre des parois dudit orifice traversant et l'élément de connexion électrique passant dans ledit orifice traversant est rempli du même matériau que celui formant le deuxième film encapsulant extérieur ;
- le premier film encapsulant extérieur comprend un troisième orifice et le premier film de protection comprend un quatrième orifice, le troisième orifice et le quatrième orifice étant alignés de manière à former un orifice traversant permettant le passage de l'élément de connexion électrique au travers du premier film encapsulant extérieur et du premier film de protection ;
- un espace entre des parois dudit orifice traversant et l'élément de connexion électrique passant dans ledit orifice traversant est rempli du même matériau que celui formant le premier film encapsulant extérieur ;
- un passage permettant la sortie de l'élément de connexion électrique au travers du film encapsulant intérieur est compris dans le film encapsulant intérieur ;
- un passage permettant la sortie de l'élément de connexion électrique au travers du film encapsulant intérieur est compris entre le premier film encapsulant extérieur et le film encapsulant intérieur ;
- un passage permettant la sortie de l'élément de connexion électrique au travers du film encapsulant intérieur est compris entre le film encapsulant intérieur et le deuxième film encapsulant extérieur ;
- une extrémité métallique dénudée dudit élément de connexion électrique est directement soudée sur une partie électriquement conductrice dudit élément électriquement ou optiquement actif ;
- une extrémité métallique dénudée de l'élément de connexion électrique est raccordée à une partie électriquement conductrice dudit élément électriquement ou optiquement actif au moyen d'un élément intermédiaire de raccordement, par exemple un ruban de cuivre plat ;
- l'élément intermédiaire de raccordement comprend une cosse ;
- l'élément de connexion électrique est un câble électrique, rond ou plat ;
- l'élément de connexion électrique est une tresse métallique plate recouverte d'une gaine thermo-rétractable ; et
- l'élément de connexion électrique présente une section inférieure ou égale à 2,5 mm2.

L'invention concerne également un procédé de fabrication selon l'objet de la revendication 21 d'un dispositif fonctionnel tel que défini précédemment. Le procédé comprend :
- une étape de raccordement de l'élément de connexion électrique à l'élément électriquement ou optiquement actif ; et
- une étape de formation de l'empilement multicouche permettant d'enrober l'élément électriquement ou optiquement actif dans l'ensemble encapsulant entre le premier film de protection et le deuxième film de protection, une extrémité de l'élément de connexion électrique sortant directement dudit dispositif fonctionnel.

D'autres caractéristiques non limitatives et avantageuses du procédé de fabrication conforme à l'invention, prises individuellement ou selon toutes les combinaisons techniquement possibles, sont les suivantes :
- l'étape de formation de l'empilement multicouche est réalisée par lamination à chaud ;
- il est prévu une étape de formation d'un passage dans ledit ensemble encapsulant, ledit passage permettant la sortie de l'élément de connexion électrique au travers dudit ensemble encapsulant ;
- il est prévu une étape de formation d'un orifice traversant au travers dudit ensemble encapsulant et dudit deuxième film de protection de manière à permettre le passage de l'élément de connexion électrique au travers dudit dispositif fonctionnel ; et
- il est prévu une étape de formation d'un orifice traversant au travers dudit ensemble encapsulant et dudit premier film de protection de manière à permettre le passage de l'élément de connexion électrique au travers dudit dispositif fonctionnel.

L'invention concerne également une chaussée circulable ou piétonne fonctionnalisée, comprenant une chaussée circulable ou piétonne sur laquelle est fixé un dispositif fonctionnel tel que défini précédemment.

L'invention concerne encore un véhicule de transport comprenant un dispositif fonctionnel tel que décrit précédemment.

L'invention concerne enfin une enveloppe de bâtiment comprenant un dispositif fonctionnel tel que décrit précédemment.

Bien entendu, les différentes caractéristiques, variantes et formes de réalisation de l'invention peuvent être associées les unes avec les autres selon diverses combinaisons dans la mesure où elles ne sont pas incompatibles ou exclusives les unes des autres.

### Description détaillée de l'invention

De plus, diverses autres caractéristiques de l'invention ressortent de la description annexée effectuée en référence aux dessins qui illustrent des formes, non limitatives, de réalisation de l'invention et où :
- la figure 1 représente, de manière schématique, une vue en coupe d'un dispositif fonctionnel selon un premier mode de réalisation de l'invention dans lequel un élément de connexion électrique sort par la face arrière du dispositif fonctionnel,
- la figure 2 représente, de manière schématique, une vue en coupe d'un dispositif fonctionnel selon un deuxième mode de réalisation de l'invention dans lequel un élément de connexion électrique sort par la face avant du dispositif fonctionnel,

- la figure 3 représente, de manière schématique, une vue en coupe d'un dispositif fonctionnel selon un troisième mode de réalisation de l'invention dans lequel un élément de connexion électrique sort par le flanc latéral du dispositif fonctionnel,
- la figure 4 représente, de manière schématique, un exemple de raccordement électrique entre un élément de connexion électrique et un connecteur électriquement conducteur conforme à l'invention,
- la figure 5 représente, de manière schématique, une vue en coupe d'un dispositif fonctionnel selon le premier mode de réalisation de l'invention dans lequel un élément de connexion électrique sort par la face arrière du dispositif fonctionnel et comprenant des cellules photovoltaïques et au moins une diode de dérivation, et
- la figure 6 représente un schéma électrique d'agencement des cellules photovoltaïques et des diodes de dérivation.

En préliminaire, on notera que les éléments identiques ou similaires des différents modes de réalisation de l'invention représentés sur les différentes figures seront, dans la mesure du possible, référencés par les mêmes signes de référence et ne seront pas décrits à chaque fois.

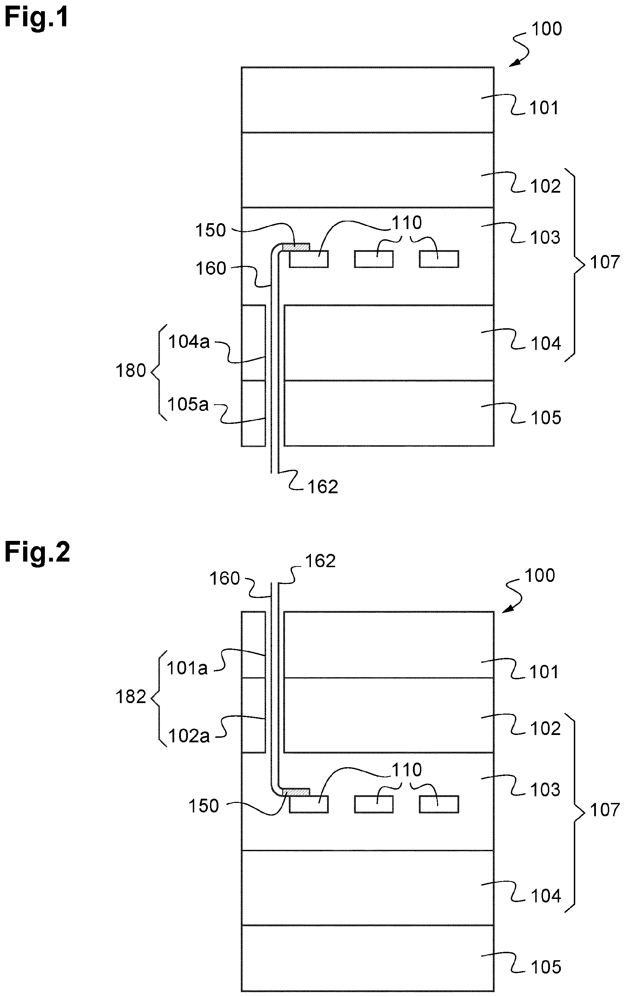

La figure 1 représente, de manière schématique, une vue en coupe d'un dispositif fonctionnel 100. Ce dispositif fonctionnel 100 est par exemple intégré sur une zone circulable telle qu'une chaussée circulable ou piétonne.

Comme le montre la figure 1, le dispositif fonctionnel 100 comprend un empilement multicouche comprenant successivement :
- une première plaque également appelée premier film de protection 101, disposée en face avant du dispositif fonctionnel 100, transparente, ayant une première épaisseur e₁, en un premier matériau, ayant un premier module d'Young E₁ et un premier coefficient de dilatation thermique CTE₁,
- un ensemble encapsulant 107 enrobant au moins un élément électriquement ou optiquement actif 110 (également appelé élément actif 110 dans la suite de cette description), et
- une deuxième plaque également appelée deuxième film de protection 105, disposée en face arrière du dispositif fonctionnel 100, transparente ou non, ayant une deuxième épaisseur es, en un deuxième matériau, ayant un deuxième module d'Young Es et un deuxième coefficient de dilatation thermique CTEs.

De manière préférentielle selon l'invention, l'ensemble encapsulant 107 comprend :
- un premier film encapsulant extérieur 102, ayant une troisième épaisseur e₂, en un troisième matériau, ayant un troisième module d'Young E₂ et un troisième coefficient de dilatation thermique CTE₂,
- un film encapsulant intérieur 103, enrobant les éléments actifs 110, le film encapsulant intérieur 103 ayant une quatrième épaisseur e₃, étant en un quatrième matériau, ayant un quatrième module d'Young E₃ et un quatrième coefficient de dilatation thermique CTE₃, et
- un deuxième film encapsulant extérieur 104, ayant une cinquième épaisseur e₄, en un cinquième matériau, ayant un cinquième module d'Young E₄ et un cinquième coefficient de dilatation thermique CTE₄.

En variante (non représentée), l'ensemble encapsulant peut être formé par seulement deux films encapsulants. En variante encore (non représentée), l'ensemble encapsulant peut être formé par un seul film encapsulant.

Dans cette description, toutes les valeurs de modules d'Young et les valeurs des coefficients de dilatation thermique sont données à température ambiante (20-25°C).

### Première plaque 101 et deuxième plaque 105 :

La première plaque 101 et la deuxième plaque 105 sont les éléments du dispositif fonctionnel 100 en contact direct avec l'environnement extérieur.

Les matériaux des plaques 101, 105 sont des matériaux ayant un module de Young élevé. De préférence, leurs modules d'Young E sont supérieurs à 2 GPa, avantageusement supérieurs à 5 GPa, encore plus avantageusement supérieurs à 10 GPa. Les modules d'Young demeurent élevés au moins sur toute la gamme de température de fonctionnement du dispositif fonctionnel 100 (de -40°C à +85°C).

La première plaque 101 et la deuxième plaque 105 présentent une grande rigidité mécanique, sont peu déformables et résistantes aux impacts.

La première plaque 101 et la deuxième plaque 105 sont réalisées en des matériaux ayant un coefficient de dilatation thermique faible. De préférence, leurs coefficients de dilation thermique CTE inférieurs à 200x10⁻⁶/K, plus préférentiellement inférieurs à 100x10⁻⁶/K, et encore plus préférentiellement inférieurs à 50x10⁻⁶/K. Elles présentent une grande stabilité dimensionnelle sous variation de température.

De préférence, les modules d'Young de la première plaque 101 et de la deuxième plaque 105 sont supérieurs à 10 GPa et leurs coefficients de dilatation thermique sont inférieurs à 50x10⁻⁶/K.

De manière avantageuse, pour éviter d'avoir un matériau qui se dilate plus que l'autre sous l'effet de la chaleur et/ou se contracte plus que l'autre sous l'effet du froid, et donc pour éviter d'induire des contraintes mécaniques inhomogènes dans l'assemblage, des matériaux ayant des valeurs de module de Young (E) et de coefficient d'expansion thermique (CTE) les plus proches possibles les uns des autres seront utilisés pour la première plaque 101 et pour la deuxième plaque 105. Par le plus proche, on entend que ces valeurs différeront de 0 à 30% maximum, de préférence de 0 à 20% et de préférence encore de 0 à 10%, et avantageusement elles sont identiques.

Comme les deux plaques (ou films) de protection 101, 105 sont en contact avec l'environnement extérieur, elles peuvent jouer également le rôle de barrières aux influences externes (notamment à l'humidité). Elles présentent, avantageusement, les caractéristiques supplémentaires suivantes :
- une grande résistance à la pénétration d'eau,
- une stabilité intrinsèque contre la dégradation structurelle par molécules d'eau,
- une grande résistance à l'exposition aux fluides chimiques.

Par exemple, les première 101 et deuxième 105 plaques sont en un matériau ayant une vitesse de transmission de la vapeur d'eau (WVTR pour « Water Vapor Transmission Rate ») le plus faible possible.

Avantageusement, la première plaque 101 et la deuxième plaque 105 sont en un matériau comprenant de 50% à 70% massique de verre pour répondre au mieux aux exigences des paramètres thermomécaniques E et CTE.

Par exemple, la première plaque 101 et la deuxième plaque 105 sont en des matériaux composites de fibres de verre et de résine ou en composite de fibres de verre et de polymère. Par exemple, il s'agit d'une résine époxyde ou acrylique, d'un polymère thermoplastique, comme une polyoléfine thermoplastique, comme le polypropylène (PP), d'un ionomère, d'un polyamide, d'un polyvinyl chloride, d'un (méth)acrylate, d'un polycarbonate, d'un polymère fluoré, ou encore d'un polyester tel que le poly(téréphtalate d'éthylène) (PET ou encore PETG).

Les fibres de verre représentent, avantageusement, de 55% à 65% massique du matériau composite. Elles peuvent être tissées (uni- ou bi-directionnelles) ou non tissées.

Les matériaux des première et deuxième plaques peuvent être différents entre eux, à condition de rester semblable en termes de module d'Young E et de coefficient de dilatation thermique CTE.

De manière préférentielle, les matériaux des première et deuxième plaques sont identiques.

La première plaque 101 et la deuxième plaque 105 ont une épaisseur allant de 0,25 à 3,0 millimètres (mm), avantageusement allant de 0,5 à 1,5 mm.

La première plaque 101 et la deuxième plaque 105 peuvent avoir des épaisseurs identiques ou différentes. De manière préférentielle, elles sont de même épaisseur.

La première plaque 101 en face avant, faisant face aux faces actives des éléments actifs 110, est transparente, de sorte à laisser passer le rayonnement solaire. Par transparent, on entend dans cette description que la première plaque 101 est formée d'un matériau laissant passer plus de 70% du rayonnement incident, et de préférence au moins 80% du rayonnement incident, dans le spectre visible.

La deuxième plaque 105 positionnée en face arrière peut être opaque ou transparente.

*Premier film encapsulant extérieur 102 et deuxième film encapsulant extérieur 104 :*
Le premier film encapsulant extérieur 102 et le deuxième film encapsulant extérieur 104 sont réalisés en des matériaux ayant des modules d'Young moyens, de préférence de 100 à 800 MPa, plus préférentiellement de 200 à 600 MPa.

Les films encapsulants extérieurs 102, 104 présentent une rigidité mécanique moyenne, sont moyennement déformables et résistants aux impacts.

Ils sont réalisés en des matériaux ayant un coefficient de dilatation thermique moyen de 200x10⁻⁶/K à 700x10⁻⁶/K, de préférence de 300x10⁻⁶/K à 600x10⁻⁶/K. Ils présentent une stabilité dimensionnelle moyenne sous variation de température.

Les matériaux des films encapsulant extérieurs 102, 104 peuvent être différents entre eux, à condition de rester semblables en termes de module d'Young E et de coefficient de dilatation thermique CTE.

De manière préférentielle, les films encapsulant extérieurs 102, 104 ont un module d'Young E de l'ordre de 500 MPa et un coefficient de dilatation thermique CTE de l'ordre de 400x10⁻⁶/K.

Les films encapsulant extérieurs 102, 104 sont, avantageusement, en des matériaux permettant de renforcer la fonction de barrière des matériaux des plaques (ou films) de protection, vis-à-vis des influences externes (notamment vis-à-vis de l'humidité).

Par exemple, les films encapsulant extérieurs 102, 104 sont en polymères, comme des homopolymères ou des copolymères d'éthylène acétate de vinyl (EVA), éthylène méthylacrylate (EMA), éthylène butylacrylate (EBA), éthylène propylène (EPDM), polyvinyl butyral (PVB), polydiméthylsiloxanes, polyuréthanes (PU), polyoléfines thermoplastiques, ionomers, polypropylène (PP), polyamide, polyvinyl chloride, polycarbonate, polymères fluorés, ou encore d'un polyester tel que le poly(téréphtalate d'éthylène) (PET ou encore PETG). De préférence, il s'agit d'un ionomère.

De préférence ici, les matériaux des deux films encapsulant extérieurs sont identiques.

Le premier film encapsulant extérieur 102 et le deuxième film encapsulant extérieur 104 ont une épaisseur comprise entre 0,25 mm à 1,0 mm, de préférence comprise entre 0,25 mm à 0,75 mm.

De manière préférentielle, le premier film encapsulant extérieur 102 et le deuxième film encapsulant extérieur 104 présentent la même épaisseur.

### Film encapsulant intérieur 103 :

Le matériau du film encapsulant intérieur 103 présente un module d'Young faible, inférieur à celui des films encapsulant extérieurs 102, 104. Son module d'Young E₃ est ici compris entre 5 et 100 MPa, de préférence entre 10 et 50 MPa.

Le film encapsulant intérieur 103 a une rigidité mécanique faible, une bonne capacité de déformation pour pouvoir absorber les contraintes et impacts mécaniques. La stabilité mécanique de l'ensemble de la structure est assurée par les autres couches du dispositif fonctionnel 100.

Le matériau du film encapsulant intérieur 103 présente un coefficient de dilatation thermique élevé, de préférence entre 800 à 2000x10⁻⁶/K, encore plus préférentiellement entre 800 à 1400x10⁻⁶/K.

De préférence, le matériau est caractérisé par un module d'Young E₃ de l'ordre de 20 MPa et un coefficient de dilation thermique CTE₃ de l'ordre de 900x10⁻⁶/K.

Le film encapsulant intérieur 103 est, par exemple, un encapsulant couramment utilisé dans le domaine du photovoltaïque.

Il peut s'agir d'un matériau polymère, comme des homopolymères ou des copolymères d'éthylène acétate de vinyl (EVA), éthylène méthylacrylate (EMA), éthylène butylacrylate (EBA), éthylène propylène (EPDM), polyvinyl butyral (PVB), polydiméthylsiloxanes, polyuréthanes (PU), polyoléfines thermoplastiques, ionomers, polypropylène (PP), polyamide, polyvinyl chloride, polycarbonate, polymères fluorés, ou encore d'un polyester tel que le poly(téréphtalate d'éthylène) (PET ou encore PETG). Il peut également s'agir d'une résine de type (méth)acrylique, ou d'un silicone réticulable à chaud ou photochimiquement. De préférence, il s'agit d'une polyoléfine thermoplastique (TPO).

Le film encapsulant intérieur 103 a une épaisseur comprise entre 0,4 à 2,0 mm, de préférence entre 0,8 à 1,4 mm.

Le film encapsulant intérieur 103 peut présenter une résistance à la pénétration d'eau élevée, une grande stabilité intrinsèque contre la dégradation structurelle par molécules d'eau ainsi qu'une résistance à l'exposition aux fluides chimiques élevée.

Avantageusement ici, la résistance à la pénétration de l'humidité des différents matériaux est croissante depuis le film encapsulant intérieur 103 vers les plaques (ou films) de protection 101 et 105, en face avant et en face arrière.

### Eléments électriquement ou optiquement actifs 110 :

Le dispositif fonctionnel 100 comprend au moins un élément électriquement ou optiquement actif 110, et de préférence, une pluralité d'éléments électriquement ou optiquement actifs 110 comme représenté sur la figure 1.

Dans cette description, on entend par « élément électriquement actif » un élément qui transmet et/ou reçoit des signaux électriques. On entend par « élément optiquement actif » un élément qui transmet et/ou reçoit des signaux optiques, ou un élément qui transforme des signaux optiques en signaux électriques ou vice versa.

Selon un premier mode de réalisation, les éléments électriquement ou optiquement actifs 110 sont disposés entre le film encapsulant intérieur 103 et le deuxième film encapsulant extérieur 104.

En variante, les éléments électriquement ou optiquement actifs 110 sont disposés entre le film encapsulant intérieur 103 et le premier film encapsulant extérieur 102.

En variante encore, les éléments électriquement ou optiquement actifs 110 sont complètement enrobés, en étant centrés ou non, dans l'épaisseur du film encapsulant intérieur 103 (comme représenté sur les figures 1 à 3).

Les éléments électriquement ou optiquement actifs pourraient également selon une autre variante être enrobés dans le film deuxième encapsulant extérieur 104. En variante encore, les éléments électriquement ou optiquement actifs pourraient être enrobés dans le premier film encapsulant extérieur 102.

Les éléments optiquement actifs sont par exemple des diodes électroluminescentes, ou un capteur photosensible (comme une photodiode).

Selon un mode de réalisation particulier ici, les éléments actifs 110 sont, par exemple, des cellules photovoltaïques. Elles sont, par exemple, à base de plaquettes de silicium, mono-cristallin, multi-cristallin ou quasi mono-cristallin également connu sous le nom anglo-saxon de « mono-like ».

Les cellules photovoltaïques sont disposées les unes à côté des autres. De manières avantageuse ici, les cellules photovoltaïques sont régulièrement espacées.

Les cellules photovoltaïques sont généralement interconnectées entre elles, par des connections métalliques électriquement conductrices, destinées à collecter l'électricité générée par les cellules photovoltaïques. Les connecteurs électriquement conducteurs, également appelés parties électriquement conductrices dans cette description, sont des connections métalliques attachées à la métallisation de la cellule. Par exemple il s'agit de rubans plats ou de fils en cuivre. Le raccordement s'effectue par exemple par soudure ou collage. L'ensemble formé par les cellules photovoltaïques et les connecteurs forme un squelette de cellules photovoltaïques interconnectées.

De manière avantageuse selon l'invention, l'un de ces connecteurs électriquement conducteurs du squelette de cellules photovoltaïques (représenté comme le connecteur électriquement conducteur 150 sur les figures 1 à 3 et 5) est raccordé, électriquement, à un élément de connexion électrique 160 permettant de transporter l'électricité générée depuis ou vers les éléments actifs 110.

Comme le montre les figures 1 à 3 et 5, une extrémité libre 162 de l'élément de connexion électrique 160 sort directement du dispositif fonctionnel 100. En d'autres termes, cet élément de connexion électrique 160 permet le transport direct d'électricité entre les éléments actifs 110 et l'extérieur du dispositif fonctionnel 100 sans boîte de jonction intermédiaire, sur la face arrière ou sur la face avant, du dispositif fonctionnel 100.

Ainsi, de manière avantageuse selon l'invention, l'élément de connexion électrique 160 est raccordé aux éléments actifs 110. Il est intégré dans l'empilement multicouche et débouche, également directement, du dispositif fonctionnel 100, sans boîte de jonction intermédiaire, sur la face arrière ou sur la face avant, du dispositif fonctionnel 100.

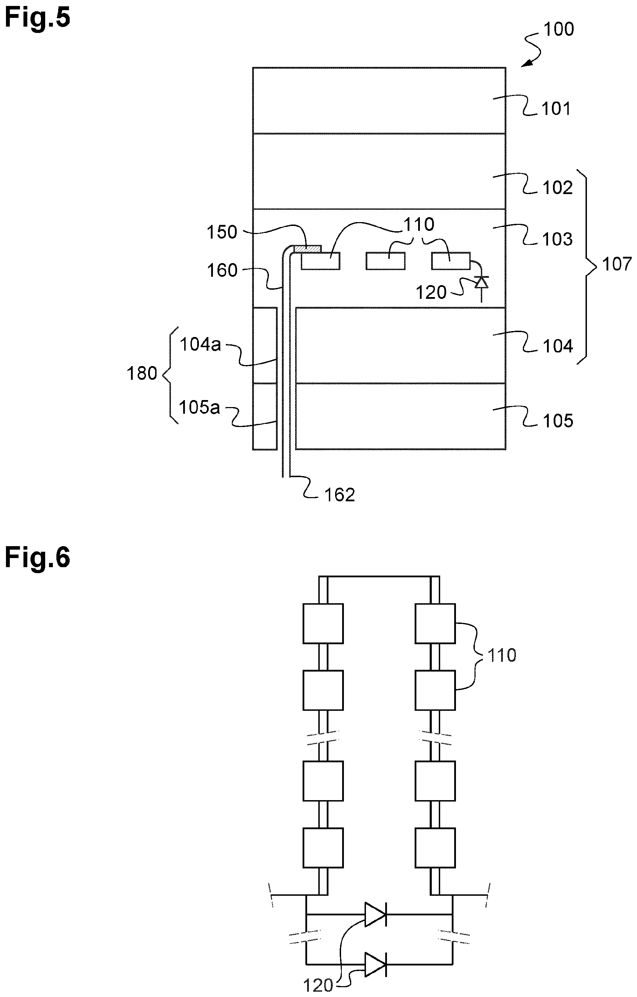

Dans le cas où les éléments actifs 110 sont des cellules photovoltaïques, le dispositif fonctionnel 100 comprend également au moins une diode de dérivation 120 (figure 5). De préférence, le dispositif fonctionnel comprend une pluralité de diodes de dérivation.

Ces diodes de dérivation 120 sont enrobées dans l'ensemble encapsulant 107 au même niveau que les éléments actifs 110, selon les différents modes de réalisation décrits précédemment pour le positionnement des éléments actifs 110 à l'intérieur de l'ensemble encapsulant 107.

En variante, les diodes de dérivation peuvent être montées sur un support, tel qu'un circuit imprimé (ou PCB pour « *Printed Circuit Board* » selon l'acronyme d'origine anglosaxonne couramment utilisée) par exemple.

De manière avantageuse, la diode de dérivation utilisée présente une faible épaisseur, c'est-à-dire une épaisseur compatible avec l'épaisseur de l'ensemble encapsulant 107. De préférence, l'épaisseur des diodes de dérivation est proche de l'épaisseur des éléments actifs 110.

Dans le cas de la variante mentionnée précédemment et utilisant un circuit imprimé sur lequel les diodes de dérivation sont montées, l'ensemble formé par le circuit imprimé et les diodes de dérivation présente, de manière avantageuse, une faible épaisseur, c'est-à-dire une épaisseur compatible avec l'épaisseur de l'ensemble encapsulant, de préférence encore une épaisseur proche de l'épaisseur des éléments actifs.

Ces diodes de dérivation sont connectées au squelette de cellules photovoltaïques. Plus particulièrement, comme représenté sur la figure 6, les diodes de dérivation 120 sont disposées selon un schéma électrique en parallèle des cellules photovoltaïques (de manière similaire au schéma classique pour les modules photovoltaïques).

De manière avantageuse selon l'invention, plusieurs diodes de dérivation sont interconnectées, en parallèle entre elles dans le schéma électrique (figure 6). Grâce à la division du courant électrique par cette pluralité de diodes de dérivation en parallèle, cet agencement permet de réduire le chauffage ohmique de chacune des diodes de dérivation individuelles. Cela permet également de répartir la charge thermique totale sur une plus grande zone, et ainsi de limiter la température maximale atteinte dans les matériaux de l'ensemble encapsulant.

Ainsi, cet agencement permet de s'affranchir d'une boîte de jonction intermédiaire classique sur l'enveloppe externe du dispositif fonctionnel tout en en conservant les fonctions de celle-ci grâce à l'intégration de l'élément de connexion électrique et des diodes de dérivation directement dans le dispositif fonctionnel, et plus particulièrement dans l'empilement multicouche.

L'élément de connexion électrique 160 est par exemple un câble électrique. De manière classique, un câble électrique 160 est formé d'une partie conductrice formée par exemple de plusieurs fils en matière conductrice, et d'une gaine extérieure, partie isolante enrobant les différents fils en matière conductrice. Par exemple ici, le câble électrique comprend une partie conductrice métallique et une gaine extérieure est formée d'un matériau polymère.

Dans la présente description, une extrémité métallique dénudée du câble électrique fait référence à une portion de ce câble dépourvue de gaine extérieure. Ainsi, le raccordement électrique du câble électrique 160 sur le connecteur électriquement conducteur 150 est effectué au moyen d'une extrémité métallique dénudée du câble électrique 160. Cette extrémité métallique dénudée est par exemple soudée sur le connecteur électriquement conducteur 150 de manière à effectuer le raccordement électrique.

Comme le montrent les figures 1 à 3 et 5, le câble électrique 160 est intégré dans les différentes couches du dispositif fonctionnel 100 afin d'effectuer une connexion électrique directe entre les éléments actifs 110 et l'extérieur du dispositif fonctionnel 100. Le câble électrique 160 s'étend au travers des différentes couches du dispositif fonctionnel 100. Plus particulièrement, de manière avantageuse selon l'invention, l'ensemble encapsulant 107 comprend un passage, au travers de l'ensemble encapsulant 107, permettant la sortie de l'élément de connexion électrique 160 vers l'extérieur du dispositif fonctionnel 100. Dans cette description, on entend par « passage » une zone de l'ensemble encapsulant traversée par l'élément de connexion électrique 160.

Tel que cela est représenté sur les figures 1 à 3 et 5, l'élément de connexion électrique 160 est enrobé d'un matériau le long de son passage au travers du dispositif fonctionnel 100. En pratique, ce matériau d'enrobage est par exemple choisi parmi l'un ou plusieurs des matériaux formant l'ensemble encapsulant 107 (donc ici parmi l'un ou plusieurs des matériaux formant le premier film encapsulant extérieur 102, le film encapsulant intérieur 103 ou le deuxième film encapsulant extérieur 104).

Selon un premier mode de réalisation représenté sur la figure 1 ou sur la figure 5, un premier orifice 104a est formé dans le deuxième film encapsulant extérieur 104 et un deuxième orifice 105a est formé dans la deuxième plaque de protection 105. Ce premier orifice 104a et ce deuxième orifice 105a sont alignés de manière à former un orifice traversant 180 le deuxième film encapsulant extérieur 104 et la deuxième plaque de protection 105 (un orifice traversant 180 unique et continu est donc formé). Cet orifice traversant 180 permet alors le passage du câble électrique 160. Comme le montrent les figures 1 et 5, dans ce mode de réalisation, le câble électrique 160 sort donc du dispositif fonctionnel 100 par la face arrière de ce dernier.

Dans cette description, on entend par « orifice » une ouverture sous la forme d'un conduit qui fait communiquer l'intérieur du dispositif fonctionnel avec l'extérieur de celui-ci.

L'orifice traversant 180 présente ici la forme d'une fente ou d'un trou. Cet orifice traversant 180 est par exemple réalisé en pratique à l'aide d'une perceuse, introduite à travers le film deuxième encapsulant extérieur 104 et la deuxième plaque de protection 105. En variante, cet orifice traversant 180 peut être réalisé à l'aide d'un outil coupant ou encore d'une machine à découpe par jet d'eau.

Selon ce premier mode de réalisation, le câble électrique 160 est donc également intégré dans le film encapsulant intérieur 103. En variante, le câble électrique peut être intégré entre le film encapsulant intérieur et le deuxième film encapsulant extérieur. En variante encore, il peut être intégré dans le deuxième film encapsulant extérieur.

En particulier, le raccordement électrique entre le câble électrique 160 et le connecteur électriquement conducteur 150 des éléments actifs 110 est également intégré dans le film encapsulant intérieur 103. En variante, ce raccordement peut être intégré entre le film encapsulant intérieur et le deuxième film encapsulant extérieur. En variante encore, il peut être intégré dans le deuxième film encapsulant extérieur.

L'espace entre le câble électrique 160 et les parois de l'orifice traversant 180 est ici rempli du même matériau que celui du deuxième film encapsulant extérieur 104. Cela garantit également une étanchéité du dispositif fonctionnel. Aucune zone ne peut ainsi faciliter la pénétration d'humidité dans le dispositif fonctionnel.

En variante, selon un deuxième mode de réalisation représenté sur la figure 2, un troisième orifice 102a est formé dans le premier film encapsulant extérieur 102 et un quatrième orifice 101a est formé dans le premier film de protection 101. Ce troisième orifice 102a et ce quatrième orifice 101a sont alignés de manière à former un orifice traversant 182 dans le premier film encapsulant extérieur 102 et la première plaque de protection 101. Cet orifice traversant 182 permet alors le passage du câble électrique 160. Comme le montre la figure 2, dans ce mode de réalisation, le câble électrique 160 sort donc du dispositif fonctionnel 100 par la face avant de ce dernier.

Comme pour le premier mode de réalisation décrit précédemment, l'orifice traversant 182 présente ici la forme d'une fente ou d'un trou. Cet orifice traversant 182 est par exemple réalisé en pratique à l'aide d'une perceuse introduite à travers le premier film encapsulant extérieur 102 et le premier film de protection 101. En variante, cet orifice traversant 182 peut être réalisé à l'aide d'un outil coupant ou encore d'une machine à découpe par jet d'eau.

Selon ce deuxième mode de réalisation, le câble électrique 160 est donc également ici intégré dans le film encapsulant intérieur 103.

En variante, le câble électrique peut être intégré entre le film encapsulant intérieur et le premier film encapsulant extérieur. En variante encore, il peut être intégré dans le premier film encapsulant extérieur.

En particulier, le raccordement électrique entre le câble électrique 160 et le connecteur électriquement conducteur 150 des éléments actifs 110 est intégré dans le film encapsulant intérieur 103.

En variante, ce raccordement peut être intégré entre le film encapsulant intérieur et le premier film encapsulant extérieur. En variante encore, il peut être intégré dans le premier film encapsulant extérieur.

L'espace entre le câble électrique 160 et les parois de l'orifice traversant 182 est ici rempli du même matériau que celui du premier film encapsulant extérieur 102. Cela garantit également une étanchéité du dispositif fonctionnel. Aucune zone ne peut ainsi faciliter la pénétration d'humidité dans le dispositif fonctionnel.

Ce deuxième mode de réalisation est particulièrement avantageux pour une utilisation dans laquelle le montage du dispositif fonctionnel sur son support ne permet pas une sortie de câble électrique par la face arrière.

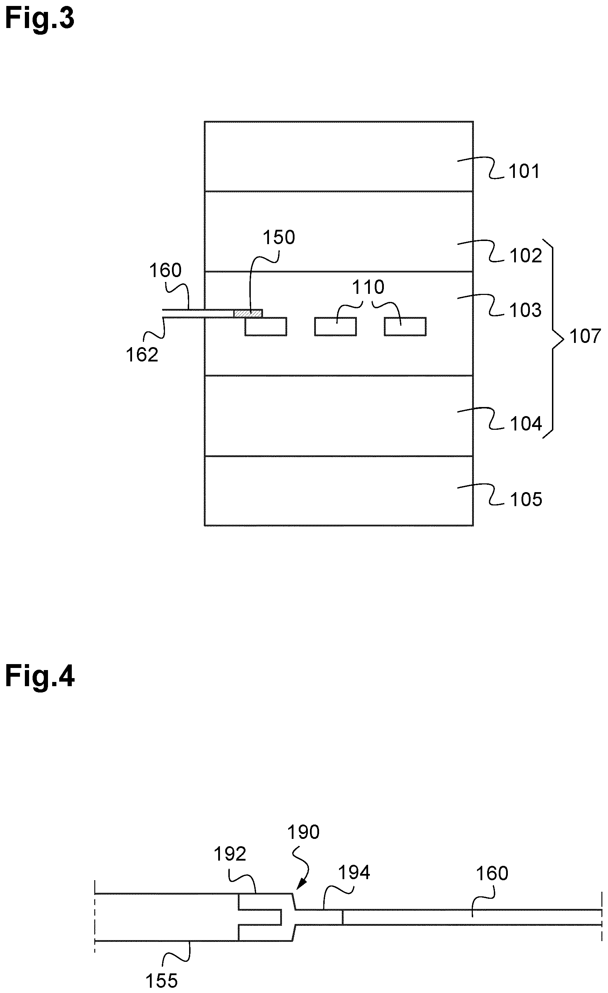

En variante encore, selon un troisième mode de réalisation représenté sur la figure 3, la sortie du câble électrique 160 du dispositif fonctionnel 100 peut s'effectuer par la tranche du dispositif fonctionnel 100. Plus précisément, dans cet exemple, l'ensemble encapsulant 107 comprend un passage permettant la sortie du câble électrique 160 vers l'extérieur du dispositif fonctionnel 100. A la différence des deux premiers modes de réalisation, aucun orifice n'est percé dans ce troisième mode de réalisation (le câble sort directement du dispositif fonctionnel).

Dans ce cas, le câble électrique 160, ainsi que son point de raccordement aux éléments actifs 110, s'étendent au travers du film encapsulant intérieur 103. Dans cet exemple, le câble électrique 160 sort donc directement par le flanc latéral du dispositif fonctionnel 100.

En variante, le câble électrique et son point de raccordement aux éléments actifs peuvent être intégrés entre le film encapsulant intérieur et le deuxième film encapsulant extérieur. En variante encore, le câble électrique et son point de raccordement aux éléments actifs peuvent être intégrés entre le film encapsulant intérieur et le premier film encapsulant extérieur.

Avantageusement selon l'invention, le câble électrique 160 présente une gaine extérieure dont le matériau est dépourvu d'éléments halogènes (comme par exemple le chlore, le fluor ou le brome). En particulier, la gaine extérieure du câble est dépourvue de fluoropolymères. En variante, la gaine extérieure du câble électrique est dépourvue de chloropolymères et/ou de bromopolymères. Cela permet d'assurer une bonne adhérence entre les différents matériaux de l'ensemble encapsulant du dispositif fonctionnel 100 et la gaine extérieure du câble électrique 160. Ceci est un facteur essentiel pour assurer une bonne étanchéité et éviter les risques de délamination au niveau de la sortie du câble électrique du dispositif fonctionnel.

La section du câble électrique 160 intégrée dans le dispositif fonctionnel 100 est déterminée en fonction du niveau de courant électrique que le câble devra supporter. Avantageusement, cette section est inférieure ou égale à 2,5 mm², ou encore avantageusement inférieure ou égale à 1,5 mm².

En pratique, le câble électrique choisi pour la présente invention présente une gamme de température d'utilisation compatible avec les conditions réelles d'utilisation du dispositif fonctionnel (de -40°C à +85°C). Le câble électrique choisi est également compatible avec des procédés de lamination usuels (par exemple ayant une température de lamination de l'ordre de 130 à 170°C et une pression de l'ordre de 1 bar) utilisés pour les modules photovoltaïques. Le câble électrique choisi présente également une bonne résistance au rayonnement ultraviolet, à l'humidité, à l'ozone et aux produits chimiques tels que les huiles, les essences ou les produits acides.

Le câble électrique peut également comprendre des agents ignifugeants de manière à retarder l'apparition de flammes lors de l'utilisation.

Des exemples de câbles électriques adaptés à être utilisés dans la présente invention sont par exemple les suivants : le câble Energyflex (Nexans) 2,5 mm², le câble Flamex EN 50264-3-1 1,5 mm² - 2,5 mm² (Nexans), le câble Varpren ST 1,5 mm² - 2,5 mm² (Omerin), le câble Varpren 155 UL 1,5 mm² - 2,5 mm² (Omerin).

En variante, en alternative du câble électrique, une tresse métallique plate peut être utilisée. Cette tresse plate présente une section avantageusement inférieure à 2 mm². Il s'agit par exemple d'une tresse de mise à la terre 30A.

Dans ce cas, la tresse plate est recouverte d'une gaine thermo-rétractable résinée, par exemple une gaine thermo rétractable TE Connectivity, Dia. 4.8mm Noir rétreint 3:1, 300mm. Cela permet de protéger la tresse plate de l'humidité et d'apporter une protection mécanique à l'ensemble.

En variante, en alternative du raccord direct du câble électrique 160 sur le connecteur électriquement conducteur 150, le raccordement électrique peut être effectué au moyen d'un élément intermédiaire, telle qu'une cosse 190.

La figure 4 représente, de manière schématique, un tel raccordement électrique au moyen d'une cosse 190. Par exemple, dans le cas où l'élément électriquement conducteur est un ruban plat métallique 155, une extrémité du ruban plat 155 est sertie dans une première partie plate 192 de la cosse 190. Cette liaison est renforcée par un apport d'étain effectué en face avant et arrière du ruban plat 155. Cela permet notamment d'assurer un bon contact électrique entre le ruban plat 155 et la cosse 190.

De l'autre côté de la cosse 190, l'extrémité métallique dénudée du câble électrique 160 est sertie dans une seconde partie 194 de la cosse 190. Cette seconde partie 194 de la cosse 190 présente par exemple un diamètre de l'ordre de 4,5 mm.

L'utilisation d'un élément intermédiaire, telle qu'une cosse 190 par exemple, permet notamment d'améliorer la manufacturabilité (c'est-à-dire la fabrication industrielle) de la connexion entre le câble électrique 160 et le connecteur électriquement conducteur 150, car elle permet d'éviter de souder directement une extrémité métallique dénudée du câble électrique sur l'élément électriquement conducteur.

Des exemples de cosses compatibles avec la présente invention sont par exemple les suivantes : RS PRO non-insulated female terminals 4 - 6 mm² (RS), RS PRO non-insulated blade terminals 4 - 6 mm² (RS), Flag Krimptite Quick Disconnect, Female, for 10-12 (3.30 to 5.00mm²) Wire, Tab 6.35 x 0.81mm (Molex) ou encore RS PRO Crimp Receptacle, 6.35 x 0.8mm, 2.5mm² to 6mm², 14AWG to 10AWG, Tin Plated (RS), RS PRO non-insulated female terminals 1,5 - 2,5 mm² (RS).

### Procédé de fabrication du dispositif fonctionnel 100 :

D'une manière générale, le procédé de fabrication du dispositif fonctionnel 100 comporte les étapes successives suivantes :
- une étape de raccordement de l'élément de connexion électrique 160 à l'élément électriquement ou optiquement actif 110 ; et
- une étape de formation de l'empilement multicouche permettant d'enrober l'élément électriquement ou optiquement actif 110 dans l'ensemble encapsulant 107 entre le premier film de protection 101 et le deuxième film de protection 105, une extrémité 162 de l'élément de connexion électrique 160 sortant directement dudit dispositif fonctionnel 100.

Dans le cas où les éléments électriquement ou optiquement actifs sont des cellules photovoltaïques, le procédé comprend également, avant l'étape de formation de l'empilement multicouche, une étape de raccordement d'au moins une diode de dérivation 120 aux cellules photovoltaïques. Cette diode de dérivation 120 est ou non montée sur un support de circuit imprimé.

La diode de dérivation 120 est ensuite également enrobée dans l'ensemble encapsulant 107 lors de l'étape de formation de l'empilement multicouche.

L'étape de formation de l'empilement multicouche est par exemple réalisée par lamination à chaud. En variante, elle peut être mise en œuvre par thermocompression, ou par infusion, ou encore par moulage par transfert de résine (ou RTM pour « *Resin Transfer Molding* » selon l'acronyme d'origine anglo-saxonne).

Plus précisément, dans le cas d'un premier mode de réalisation du procédé de fabrication du dispositif fonctionnel 100 (représenté sur la figure 1), le procédé de fabrication du dispositif fonctionnel 100 comprend, dans cet ordre, les étapes suivantes :
- positionnement du deuxième film de protection 105 disposé en arrière dudit dispositif fonctionnel 100,
- positionnement de l'ensemble encapsulant,
- formation de l'orifice traversant 180 au travers au travers dudit ensemble encapsulant et dudit deuxième film de protection 105 de manière à permettre le passage de l'élément de connexion électrique 160 au travers dudit dispositif fonctionnel 100,
- positionnement de l'élément de connexion électrique 160 et de l'élément électriquement ou optiquement actif 110, l'élément de connexion électrique 160 passant au travers de l'orifice traversant 180 de manière qu'une extrémité 162 de l'élément de connexion électrique 160 sorte directement du dispositif fonctionnel,
- raccordement de l'élément de connexion électrique 160 à l'élément électriquement ou optiquement actif 110,
- positionnement du premier film de protection 101 disposé en avant dudit dispositif fonctionnel 100, et
- lamination à chaud de l'assemblage.

Selon ce premier mode de réalisation, le dispositif fonctionnel 100 est donc fabriqué par empilement depuis la face arrière vers la face avant du dispositif.

Dans ce mode de réalisation, le procédé comprend également une étape de la fourniture d'une couche de téflon, temporairement pendant la lamination, positionnée entre le deuxième film de protection 105 et une portion de l'élément de connexion électrique 160 sortant dudit dispositif fonctionnel 100. Cette couche de téflon permet notamment d'éviter que l'élément de connexion électrique 160 ne soit encastré de manière irréversible dans le deuxième film de protection 105 lors du procédé de fabrication.

Selon un deuxième mode de réalisation du procédé de fabrication du dispositif fonctionnel 100 (représenté sur la figure 2), le procédé de fabrication du dispositif fonctionnel 100 comprend, dans cet ordre, les étapes suivantes :
- positionnement du premier film de protection 101 disposé en avant dudit dispositif fonctionnel 100,
- positionnement de l'ensemble encapsulant 107,
- formation de l'orifice traversant 182 au travers au travers dudit ensemble encapsulant 107 et dudit premier film de protection 102 de manière à permettre le passage de l'élément de connexion électrique 160 au travers dudit dispositif fonctionnel,
- positionnement de l'élément de connexion électrique 160 et de l'élément électriquement ou optiquement actif 110, l'élément de connexion électrique 160 passant au travers de l'orifice traversant 182 de manière qu'une extrémité 162 de l'élément de connexion électrique 160 sorte directement du dispositif fonctionnel,
- raccordement de l'élément de connexion électrique 160 à l'élément électriquement ou optiquement actif 110,
- positionnement du deuxième film de protection 105 disposé en arrière dudit dispositif fonctionnel 100, et
- lamination à chaud de l'assemblage.

Selon ce deuxième mode de réalisation, le dispositif fonctionnel 100 est fabriqué par empilement depuis la face avant vers la face arrière du dispositif fonctionnel 100.

Selon un troisième mode de réalisation du procédé de fabrication du dispositif fonctionnel 100 (représenté sur la figure 3), le procédé de fabrication du dispositif fonctionnel 100 comprend, dans cet ordre, les étapes suivantes :
- positionnement du deuxième film de protection 105 disposé en arrière dudit dispositif fonctionnel 100,
- positionnement de l'ensemble encapsulant de manière à former un passage dans l'ensemble encapsulant, ce passage permettant la sortie de l'élément de connexion électrique vers l'extérieur du dispositif fonctionnel 100,
- positionnement de l'élément de connexion électrique 160 et de l'élément électriquement ou optiquement actif 110, l'élément de connexion électrique 160 s'étendant au travers du passage former dans l'ensemble encapsulant de manière qu'une extrémité 162 de l'élément de connexion électrique 160 sorte directement du dispositif fonctionnel,
- raccordement de l'élément de connexion électrique 160 à l'élément électriquement ou optiquement actif 110,
- positionnement du premier film de protection 101 disposé en avant dudit dispositif fonctionnel 100, et
- lamination à chaud de l'assemblage.

En variante, pour ce troisième mode de réalisation du procédé de fabrication du dispositif fonctionnel 100 (représenté sur la figure 3), le procédé de fabrication du dispositif fonctionnel 100 comprend, dans cet ordre, les étapes suivantes :
- positionnement du premier film de protection 101 disposé en avant dudit dispositif fonctionnel 100,
- positionnement de l'ensemble encapsulant de manière à former un passage dans l'ensemble encapsulant, ce passage permettant la sortie de l'élément de connexion électrique vers l'extérieur du dispositif fonctionnel 100,
- positionnement de l'élément de connexion électrique 160 et de l'élément électriquement ou optiquement actif 110, l'élément de connexion électrique 160 s'étendant au travers du passage former dans l'ensemble encapsulant de manière qu'une extrémité 162 de l'élément de connexion électrique 160 sorte directement du dispositif fonctionnel,

- raccordement de l'élément de connexion électrique 160 à l'élément électriquement ou optiquement actif 110,
- positionnement du deuxième film de protection 105 disposé en arrière dudit dispositif fonctionnel 100, et
- lamination à chaud de l'assemblage.

En d'autres termes, ce troisième mode de réalisation du procédé de fabrication peut être mis en œuvre, de manière indifférente, par empilement de la face arrière vers la face avant du dispositif ou inversement.

L'orifice traversant permet le passage de l'élément de connexion électrique afin de sortir son extrémité 162 libre du dispositif fonctionnel 100 (l'autre extrémité étant raccordée à un élément électriquement conducteur relié à l'élément électriquement ou optiquement actif). L'orifice traversant est réalisé dans les couches concernées par perçage, par exemple à l'aide d'une perceuse ou d'un outil coupant ou d'une machine à découpe par jet d'eau tel que mentionné précédemment.

La lamination à chaud de l'ensemble (aussi appelée laminage) permet, non seulement, de faire fondre puis réticuler ou polymériser les matériaux polymères mais, également, de constituer une bonne adhérence entre toutes les couches, les éléments électriquement ou optiquement actifs et l'élément de connexion électrique, formant l'ensemble de la structure.

Chaque film encapsulant 102, 103 et 104 ; ainsi que les plaques ou films de protection 101 et 105 ; peut être obtenu à partir d'une ou plusieurs couches empilées d'un même matériau ; afin d'obtenir l'épaisseur souhaitée pour chaque film ou plaque dans son état final ; après la lamination.

La lamination est exécutée à l'aide d'un équipement dit laminateur (aussi appelé laminoir) pouvant être, par exemple, une presse à membrane ou une presse double-plateaux.

Le procédé de lamination est réalisé à chaud sous vide et sous pression mécanique. La température de lamination est entre 120°C et 200 °C, et avantageusement entre 140 et 170 °C, avec un temps de procédé ajustable. Ce temps de procédé est par exemple compris entre 15 et 30 minutes. La pression appliquée est typiquement de l'ordre d'un bar.

### Applications

La présente invention concerne de manière avantageuse les dispositifs fonctionnels pour des routes solaires, et en particulier les modules photovoltaïques. L'invention s'applique également de manière avantageuse à des dispositifs fonctionnels destinés à être positionnés sur une chaussée et intégrant d'autres éléments électriquement ou optiquement actifs ou passifs.

En particulier, le dispositif fonctionnel 100 est intégrable à la surface de chaussées circulables - pour tout moyen de transport roulant, motorisé et/ou non motorisé, et/ou piéton. Plus de détails sur les caractéristiques d'une telle chaussée peuvent être trouvés dans le document FR3093116.

L'invention s'applique également de manière avantageuse aux véhicules de transport, tels que les véhicules automobiles, les trains ou les bateaux. Le dispositif fonctionnel selon l'invention est par exemple intégré sur une surface extérieure d'un véhicule de transport.

Enfin, l'invention trouve également une application privilégiée dans tous les domaines usuels dans lesquels des modules photovoltaïques sont inclus. En particulier, le dispositif fonctionnel selon l'invention est intégrable à la surface d'une enveloppe d'un bâtiment. Par enveloppe d'un bâtiment, on entend ici la toiture ou la façade d'un bâtiment. Le dispositif fonctionnel selon l'invention peut avantageusement être installé sur une toiture plane ou une toiture inclinée.

## Revendications

1. Dispositif fonctionnel (100) comportant un empilement multicouche comprenant successivement :
- un premier film de protection (101) transparent disposé en face avant dudit dispositif (100),
- un ensemble encapsulant (107),
- un deuxième film de protection (105), transparent ou non, disposé en face arrière du dispositif,
- au moins un élément électriquement ou optiquement actif (110) étant enrobé dans l'ensemble encapsulant (107), et
- un élément de connexion électrique (160) raccordé audit élément électriquement ou optiquement actif (110) et adapté à transporter l'électricité depuis ou vers ledit élément électriquement ou optiquement actif (110),
**caractérisé en ce que** l'élément de connexion électrique (160) est intégré dans l'empilement multicouche et,
**en ce que** ledit élément de connexion électrique (160) comprend une gaine extérieure dépourvue d'éléments halogènes et dont une extrémité (162) sort directement dudit dispositif fonctionnel (100), de manière à s'affranchir de l'utilisation d'une boîte de jonction intermédiaire en face avant ou en face arrière du dispositif fonctionnel (100).

2. Dispositif fonctionnel (100) selon la revendication 1, dans lequel l'élément électriquement ou optiquement actif (110) est une cellule photovoltaïque, ladite cellule photovoltaïque étant raccordée à au moins une diode de dérivation enrobée dans l'ensemble encapsulant (107).

3. Dispositif fonctionnel (100) selon la revendication 1 ou 2, dans lequel la gaine extérieure de l'élément de connexion électrique (160) est dépourvue de fluoropolymère et/ou de chloropolymère et/ou de bromopolymère.

4. Dispositif fonctionnel (100) selon l'une quelconque des revendications 1 à 3, dans lequel l'ensemble encapsulant (107) comprend un passage permettant la sortie de l'élément de connexion électrique (160), au travers de l'ensemble encapsulant (107), vers l'extérieur du dispositif fonctionnel (100).

5. Dispositif fonctionnel (100) selon l'une quelconque des revendications 1 à 4, dans lequel l'ensemble encapsulant (107) comprend :
- un premier film encapsulant extérieur (102),
- un film encapsulant intérieur (103), et
- un deuxième film encapsulant extérieur (104).

6. Dispositif fonctionnel (100) selon la revendication 5, dans lequel l'élément de connexion électrique (160) est enrobé de matériau encapsulant le long de son passage au travers dudit dispositif fonctionnel (100), ledit matériau encapsulant étant choisi parmi l'un ou plusieurs des matériaux formant le premier film encapsulant extérieur (102), le film encapsulant intérieur (103) ou le deuxième film encapsulant extérieur (104).

7. Dispositif fonctionnel (100) selon la revendication 5 ou 6, dans lequel le deuxième film encapsulant extérieur (104) comprend un premier orifice (104a) et le deuxième film de protection (105) comprend un deuxième orifice (105a), le premier orifice (104a) et le deuxième orifice (105a) étant alignés de manière à former un orifice traversant (180) permettant le passage de l'élément de connexion électrique (160) au travers du deuxième film encapsulant extérieur (104) et du deuxième film de protection (105).

8. Dispositif fonctionnel (100) selon la revendication 7, dans lequel un espace entre des parois dudit orifice traversant (180) et l'élément de connexion électrique (160) passant dans ledit orifice traversant (180) est rempli du même matériau que celui formant le deuxième film encapsulant extérieur (104).

9. Dispositif fonctionnel (100) selon la revendication 5 ou 6, dans lequel le premier film encapsulant extérieur (102) comprend un troisième orifice (102a) et le premier film de protection (101) comprend un quatrième orifice (101a), le troisième orifice (102a) et le quatrième orifice (101a) étant alignés de manière à former un orifice traversant (182) permettant le passage de l'élément de connexion électrique (160) au travers du premier film encapsulant extérieur (102) et du premier film de protection (101).

10. Dispositif fonctionnel (100) selon la revendication 9, dans lequel un espace entre des parois dudit orifice traversant (182) et l'élément de connexion électrique (160) passant dans ledit orifice traversant (182) est rempli du même matériau que celui formant le premier film encapsulant extérieur (102).

11. Dispositif fonctionnel (100) selon la revendication 5 ou 6, dans lequel un passage permettant la sortie de l'élément de connexion électrique au travers du film encapsulant intérieur (103) est compris dans le film encapsulant intérieur (103) ou entre le premier film encapsulant extérieur (102) et le film encapsulant intérieur (103) ou entre le film encapsulant intérieur (103) et le deuxième film encapsulant extérieur (104).

12. Dispositif fonctionnel (100) selon l'une quelconque des revendications 1 à 11, dans lequel une extrémité métallique dénudée dudit élément de connexion électrique (160) est directement soudée sur une partie électriquement conductrice (150) dudit élément électriquement ou optiquement actif (110).

13. Dispositif fonctionnel (100) selon l'une quelconque des revendications 1 à 11, dans lequel une extrémité métallique dénudée de l'élément de connexion électrique (160) est raccordée à une partie électriquement conductrice (150) dudit élément électriquement ou optiquement actif (110) au moyen d'un élément intermédiaire de raccordement (190), par exemple un ruban de cuivre plat.

14. Dispositif fonctionnel (100) selon la revendication 12, dans lequel l'élément intermédiaire de raccordement (190) comprend une cosse.

15. Dispositif fonctionnel (100) selon l'une quelconque des revendications 1 à 14, dans lequel l'élément de connexion électrique (160) est un câble électrique, rond.

16. Dispositif fonctionnel (100) selon l'une quelconque des revendications 1 à 14, dans lequel l'élément de connexion électrique (160) est une tresse métallique plate recouverte d'une gaine thermo-rétractable.

17. Dispositif fonctionnel (100) selon l'une quelconque des revendications 1 à 16, dans lequel l'élément de connexion électrique (160) présente une section inférieure ou égale à 2,5 mm².

18. Chaussée circulable ou piétonne fonctionnalisée, comprenant une chaussée circulable ou piétonne sur laquelle est fixé un dispositif fonctionnel (100) tel que défini dans l'une quelconque des revendications 1 à 17.

19. Véhicule de transport comprenant un dispositif fonctionnel (100) selon l'une quelconque des revendications 1 à 17.

20. Enveloppe de bâtiment comprenant un dispositif fonctionnel (100) selon l'une quelconque des revendications 1 à 17.

21. Procédé de fabrication d'un dispositif fonctionnel (100) selon l'une quelconque des revendications 1 à 17, ledit procédé comprenant :
- une étape de raccordement de l'élément de connexion électrique (160) à l'élément électriquement ou optiquement actif (110) ; et
- une étape de formation de l'empilement multicouche permettant d'enrober l'élément électriquement ou optiquement actif (110) dans l'ensemble encapsulant (107) entre le premier film de protection (101) et le deuxième film de protection (105), une extrémité (162) de l'élément de connexion électrique (160) qui comprend une gaine extérieure dépourvue d'éléments halogènes, sortant directement dudit dispositif fonctionnel (100).

22. Procédé de fabrication selon la revendication 21, dans lequel l'étape de formation de l'empilement multicouche est réalisée par lamination à chaud.

23. Procédé de fabrication selon la revendication 21 ou 22, comprenant une étape de formation d'un passage dans ledit ensemble encapsulant (107), ledit passage permettant la sortie de l'élément de connexion électrique (160) au travers dudit ensemble encapsulant (107).

24. Procédé de fabrication selon l'une quelconque des revendications 21 à 23, comprenant une étape de formation d'un orifice traversant (180) au travers dudit ensemble encapsulant (107) et dudit deuxième film de protection (105) de manière à permettre le passage de l'élément de connexion électrique (160) au travers dudit dispositif fonctionnel (100).

25. Procédé de fabrication selon l'une quelconque des revendications 21 à 23, comprenant une étape de formation d'un orifice traversant (180) au travers dudit ensemble encapsulant (107) et dudit premier film de protection (101) de manière à permettre le passage de l'élément de connexion électrique (160) au travers dudit dispositif fonctionnel (100).

## Patentansprüche

1. Funktionseinrichtung (100) mit einer mehrschichtigen Aufschichtung, die der Reihenfolge nach
- einen auf der Vorderseite der Einrichtung (100) angeordneten durchsichtigen ersten Schutzfilm (101),
- eine Einkapselungseinheit (107),
- einen auf der Rückseite der Einrichtung angeordneten durchsichtigen oder undurchsichtigen zweiten Schutzfilm (105),
- wobei mindestens ein elektrisch oder optisch aktives Element (110) in der Einkapselungseinheit (107) umhüllt ist, und
- ein mit dem elektrisch oder optisch aktiven Element (110) verbundenes und für den Transport von Elektrizität vom oder zum elektrisch oder optisch aktiven Element (110) ausgelegtes elektrisches Verbindungselement (160)
aufweist,
**dadurch gekennzeichnet, daß** das elektrische Verbindungselement (160) in der mehrschichtigen Aufschichtung integriert ist und
daß das elektrische Verbindungselement (160) eine von halogenen Elementen freie äußere Ummantelung aufweist, von der ein Ende (162) direkt aus der Funktionseinrichtung (100) herauskommt, um von der Verwendung einer Zwischenverbindungsbox an der Vorderseite oder an der Rückseite der Funktionseinrichtung (100) frei zu sein.

2. Funktionseinrichtung (100) gemäß Anspruch 1, bei der das elektrisch oder optisch aktive Element (110) eine Solarzelle ist, wobei die Solarzelle mit mindestens einer in der Einkapselungseinheit (107) eingekapselten Bypass-Diode verbunden ist.

3. Funktionseinrichtung (100) gemäß Anspruch 1 oder 2, bei der die äußere Ummantelung des elektrischen Verbindungselements (160) von Fluorpolymeren und/oder Chlorpolymeren und/oder Brompolymeren frei ist.

4. Funktionseinrichtung (100) gemäß einem der Ansprüche 1 bis 3, bei der die Einkapselungseinheit (107) einen Durchgang aufweist, der den Ausgang des elektrischen Verbindungselements (160) durch die Einkapselungseinheit (107) nach außerhalb der Funktionseinrichtung (100) ermöglicht.

5. Funktionseinrichtung (100) gemäß einem der Ansprüche 1 bis 4, bei der die Einkapselungseinheit (107)
- einen ersten äußeren Einkapselungsfilm (102),
- einen inneren Einkapselungsfilm (103) und
- einen zweiten äußeren Einkapselungsfilm (104)
aufweist.

6. Funktionseinrichtung (100) gemäß Anspruch 5, bei der das elektrische Verbindungselement (160) entlang des Durchgangs durch die Funktionseinrichtung (100) mit einem Einkapselungsmaterial umhüllt ist, wobei das Einkapselungsmaterial aus einem oder mehreren der Materialien ausgewählt ist, das bzw. die den ersten äußeren Einkapselungsfilm (102), den inneren Einkapselungsfilm (103) oder den zweiten äußeren Einkapselungsfilm (104) bildet bzw. bilden.

7. Funktionseinrichtung (100) gemäß Anspruch 5 oder 6, bei der der zweite äußere Einkapselungsfilm (104) ein erstes Loch (104a) und der zweite Schutzfilm (105) ein zweites Loch (105a) aufweisen, wobei des erste Loch (104a) und das zweite Loch (105a) so aufeinander ausgerichtet sind, daß sie ein Durchgangsloch (180) bilden, das den Durchgang des elektrischen Verbindungselements (160) durch den zweiten äußeren Einkapselungsfilm (104) und den zweiten Schutzfilm (105) ermöglicht.

8. Funktionseinrichtung (100) gemäß Anspruch 7, bei der ein Raum zwischen den Wandungen des Durchgangslochs (180) und des durch das Durchgangsloch (180) gehenden elektrischen Verbindungselements (160) mit demselben Material angefüllt ist wie das, das den zweiten äußeren Einkapselungsfilm (104) bildet.

9. Funktionseinrichtung (100) gemäß Anspruch 5 oder 6, bei der der erste äußere Einkapselungsfilm (102) ein drittes Loch (102a) aufweist und der erste Schutzfilm (101) ein viertes Loch (101a) aufweist, wobei das dritte Loch (102a) und das vierte Loch (101a) so aufeinander ausgerichtet sind, daß sie ein Durchgangsloch (182) bilden, das den Durchgang des elektrischen Verbindungselements (160) durch den ersten äußeren Einkapselungsfilm (102) und den ersten Schutzfilm (101) ermöglicht.

10. Funktionseinrichtung (100) gemäß Anspruch 9, bei der ein Raum zwischen den Wandungen des Durchgangslochs (182) und des durch das Durchgangsloch (182) gehenden elektrischen Verbindungselements (160) mit demselben Material angefüllt ist wie das, das den ersten äußeren Einkapselungsfilm (102) bildet.

11. Funktionseinrichtung (100) gemäß Anspruch 5 oder 6, bei der ein Durchgang, der den Ausgang des elektrischen Verbindungselements durch den inneren Einkapselungsfilm (103) ermöglicht, im inneren Einkapselungsfilm (103) oder zwischen dem ersten äußeren Einkapselungsfilm (102) und dem inneren Einkapselungsfilm (103) oder zwischen dem inneren Einkapselungsfilm (103) und dem zweiten äußeren Einkapselungsfilm (104) enthalten ist.

12. Funktionseinrichtung (100) gemäß einem der Ansprüche 1 bis 11, bei der ein abisoliertes metallisches Ende des elektrischen Verbindungselements (160) direkt auf einen elektrisch leitenden Teil (150) des elektrisch oder optisch aktiven Elements (110) gelötet ist.

13. Funktionseinrichtung (100) gemäß einem der Ansprüche 1 bis 11, bei der ein abisoliertes metallisches Ende des elektrischen Verbindungselements (160) mittels eines Verbindungszwischenelements (190), zum Beispiel eines flachen Kupferbands, mit einem elektrisch leitenden Teil (150) des elektrisch oder optisch aktiven Elements (110) verbunden ist.

14. Funktionseinrichtung (100) gemäß Anspruch 12, bei der das Verbindungszwischenelement (190) eine Klemme aufweist.

15. Funktionseinrichtung (100) gemäß einem der Ansprüche 1 bis 14, bei der das elektrische Verbindungselement (160) ein rundes elektrisches Kabel ist.

16. Funktionseinrichtung (100) gemäß einem der Ansprüche 1 bis 14, bei der das elektrische Verbindungselement (160) ein mit einem Schrumpfschlauch überzogenes metallisches Geflecht ist.

17. Funktionseinrichtung (100) gemäß einem der Ansprüche 1 bis 16, bei der das elektrische Verbindungselement (160) einen Querschnitt von weniger als oder gleich 2,5 mm² aufweist.

18. Funktionalisierte befahrbare oder Fußgängerchaussee mit einer befahrbaren oder Fußgängerchaussee, auf der eine wie in einem der Ansprüche 1 bis 17 definierte Funktionseinrichtung (100) befestigt ist.

19. Transportfahrzeug mit einer Funktionseinrichtung (100) gemäß einem der Ansprüche 1 bis 17.

20. Gebäudehülle mit einer Funktionseinrichtung (100) gemäß einem der Ansprüche 1 bis 17.

21. Verfahren zum Herstellen einer Funktionseinrichtung (100) gemäß einem der Ansprüche 1 bis 17, wobei das Verfahren
- einen Schritt des Verbindens des elektrischen Verbindungselements (160) mit dem elektrisch oder optisch aktiven Element (110) und
- einen Schritt des Bildens einer mehrschichtigen Aufschichtung, die ermöglicht, das elektrisch oder optisch aktive Element (110) in der Einkapselungseinheit (107) zwischen dem ersten Schutzfilm (101) und dem zweiten Schutzfilm einzukapseln, wobei ein Ende (162) des elektrischen Verbindungselements (160), das eine halogenfreie äußere Umhüllung aufweist, direkt aus der Funktionseinrichtung (100) herauskommt,
aufweist.

22. Herstellungsverfahren gemäß Anspruch 21, bei dem der Schritt des Bildens der mehrschichtigen Aufschichtung durch Heißlaminieren ausgeführt wird.

23. Herstellungsverfahren gemäß Anspruch 21 oder 22 mit einem Schritt des Bildens eines Durchgangs in der Einkapselungseinheit (107), wobei der Durchgang das Herausführen des elektrischen Verbindungselements (160) durch die Einkapselungseinheit (107) ermöglicht.

24. Herstellungsverfahren gemäß einem der Ansprüche 21 bis 23 mit einem Schritt des Bildens eines Durchgangslochs (180) durch die Einkapselungseinheit (107) und den zweiten Schutzfilm (105), um den Durchgang des elektrischen Verbindungselements (160) durch die Funktionseinrichtung (100) zu ermöglichen.

25. Herstellungsverfahren gemäß einem der Ansprüche 21 bis 23 mit einem Schritt des Bildens eines Durchgangslochs (180) durch die Einkapselungseinheit (107) und den ersten Schutzfilm (101), um den Durchgang des elektrischen Verbindungselements (160) durch die Funktionseinrichtung (100) zu ermöglichen.

## Claims

1. A functional device (100) including a multilayer stack comprising, in succession:
- a first, transparent, protective film (101), arranged on the front side of said device (100),
- an encapsulating assembly (107),
- a second protective film (105), transparent or not, arranged on the back side of the device,
- at least one electrically or optically active element (110) embedded in the encapsulating assembly (107), and
- an electrical connection element (160) connected to said electrically or optically active element (110) and suitable for transporting electricity from or to said electrically or optically active element (110),
**characterized in that** the electrical connection element (160) is integrated into the multilayer stack,
**in that** said electrical connection element (160) comprises an outer sheath free from halogen elements and an end (162) of which exits directly from said functional device (100), so as to eliminate the need for an intermediate junction box on the front side or the back side of the functional device (100).

2. The functional device (100) according to claim 1, wherein the electrically or optically active element (110) is a photovoltaic cell, said photovoltaic cell being connected to at least one bypass diode embedded in the encapsulating assembly (107).

3. The functional device (100) according to claim 1 or 2, wherein the outer sheath of the electrical connection element (160) is free from fluoropolymer and/or chloropolymer and/or bromopolymer.

4. The functional device (100) according to any one of claims 1 to 3, wherein the encapsulating assembly (107) comprises a passage for the exit of the electrical connection element (160), through the encapsulating assembly (107), outside the functional device (100).

5. The functional device (100) according to any one of claims 1 to 4, wherein the encapsulating assembly (107) comprises:
- a first outer encapsulating film (102),
- an inner encapsulating film (103), and
- a second outer encapsulating film (104).

6. The functional device (100) according to claim 5, wherein the electrical connection element (160) is embedded in an encapsulating material along its passage through said functional device (100), said encapsulating material being chosen among one or more of the materials forming the first outer encapsulating film (102), the inner encapsulating film (103) or the second outer encapsulating film (104).

7. The functional device (100) according to claim 5 or 6, wherein the second outer encapsulating film (104) comprises a first orifice (104a) and the second protective film (105) comprises a second orifice (105a), the first orifice (104a) and the second orifice (105a) being aligned in such a way as to form a through-orifice (180) for the passage of the electrical connection element (160) through the second outer encapsulating film (104) and the second protective film (105).

8. The functional device (100) according to claim 7, wherein a space between walls of said through-orifice (180) and the electrical connection element (160) passing through said through-orifice (180) is filled with the same material as that forming the second outer encapsulating film (104).

9. The functional device (100) according to claim 5 or 6, wherein the first outer encapsulating film (102) comprises a third orifice (102a) and the first protective film (101) comprises a fourth orifice (101a), the third orifice (102a) and the fourth orifice (101a) being aligned in such a way as to form a through-orifice (182) for the passage of the electrical connection element (160) through the first outer encapsulating film (102) and the first protective film (101).

10. The functional device (100) according to claim 9, wherein a space between walls of said through-orifice (182) and the electrical connection element (160) passing through said through-opening (182) is filled with the same material as that forming the first outer encapsulating film (102).

11. The functional device (100) according to claim 5 or 6, wherein a passage for the exit of the electrical connection element through the inner encapsulating film (103) is included in the inner encapsulating film (103) or between the first outer encapsulating film (102) and the inner encapsulating film (103) or between the inner encapsulating film (103) and the second outer encapsulating film (104).

12. The functional device (100) according to any one of claims 1 to 11, wherein a stripped metal end of said electrical connection element (160) is directly welded to an electrically conductive part (150) of said electrically or optically active element (110).

13. The functional device (100) according to any one of claims 1 to 11, wherein a stripped metal end of the electrical connection element (160) is connected to an electrically conductive part (150) of said electrically or optically active element (110) by means of an intermediate connection element (190), e.g. a flat copper tape.

14. The functional device (100) according to claim 12, wherein the intermediate connection element (190) comprises a terminal.

15. The functional device (100) according to any one of claims 1 to 14, wherein the electrical connection element (160) is a round electrical cable.

16. The functional device (100) according to any one of claims 1 to 14, wherein the electrical connection element (160) is a flat metal braid covered with a heat-shrinkable sheath.

17. The functional device (100) according to any one of claims 1 to 16, wherein the electrical connection element (160) has a cross-section less than or equal to 2.5 mm².

18. A functionalised trafficable or pedestrian roadway, comprising a trafficable or pedestrian roadway on which is fastened a functional device (100) as defined in any one of claims 1 to 17.

19. A transport vehicle comprising a functional device (100) according to any one of claims 1 to 17.

20. A building envelope comprising a functional device (100) according to any one of claims 1 to 17.

21. A method for manufacturing a functional device (100) according to any one of claims 1 to 17, said method comprising:
- a step of connecting the electrical connection element (160) to the electrically or optically active element (110); and
- a step of forming the multilayer stack for embedding the electrically or optically active element (110) into the encapsulating assembly (107) between the first protective film (101) and the second protective film (105), an end (162) of the electrical connection element (160), that comprises an outer sheath free from halogen elements, exiting directly from said functional device (100).

22. The manufacturing method according to claim 21, wherein the step of forming the multilayer stack is made by hot lamination.

23. The manufacturing method according to claim 21 or 22, comprising a step of forming a passage into said encapsulating assembly (107), said passage allowing the exit of the electrical connection element (160) through said encapsulating assembly (107).

24. The manufacturing method according to any one of claims 21 to 23, comprising a step of forming a through-orifice (180) through said encapsulating assembly (107) and said second protective film (105) for the passage of the electrical connection element (160) through said functional device (100).

25. The manufacturing method according to any one of claims 21 to 23, comprising a step of forming a through-opening (180) through said encapsulating assembly (107) and said first protective film (101) for the passage of the electrical connection element (160) through said functional device (100).
